# EUROPEAN PATENT SPECIFICATION

(11) **EP 4 160 899 B1**
(45) Date of publication and mention of the grant of the patent: **28.01.2026**
(21) Application number: 21813409.6
(22) Date of filing: 30.04.2021
(51) Int. Cl.: H02M 7/48, H02M 1/00, H03K 17/0812, H03K 17/18

(54) **FAULT DETECTION DEVICE AND METHOD THEREFOR**
FEHLERERKENNUNGSVORRICHTUNG UND VERFAHREN DAFÜR
DISPOSITIF DE DÉTECTION DE DÉFAUT ET SON PROCÉDÉ

(30) Priority: 27.05.2020 JP 2020092114
(43) Date of publication of application: 05.04.2023
(73) Proprietor: Hitachi, Ltd., Tokyo 100-8280 (JP)
(72) Inventor: KOUNO, Yasuhiko, Tokyo 100-8280 (JP)
(74) Representative: Mewburn Ellis LLP
(86) International application number: PCT/JP2021/017160
(87) International publication number: WO 2021/241137

(56) References cited:
- DE-T5- 112018 003 834
- JP-A- 2003 143 833
- JP-A- 2007 295 687
- JP-A- 2015 070 754
- US-A1- 2017 288 385
- US-B2- 10 790 813

## Description

### Technical Field

The present invention relates to a fault detection device and a fault detection method for a semiconductor element drive circuit, and particularly relates to detection of disconnection of a gate wiring of a semiconductor element.

### Background Art

An insulated gate bipolar transistor (IGBT) called a power semiconductor, a power metal-oxide-semiconductor field effect transistor (MOSFET), or the like is used for a power conversion device used for driving a motor in an electric vehicle, a railway vehicle, a steel mill, or the like. The IGBT and the power MOSFET are called voltage-driven elements, and conduction states (on and off) can be controlled by controlling a voltage of a gate electrode.

An IGBT for a power conversion device that is widely used at present is an n-channel type element that is turned on when a predetermined positive voltage is applied to a gate electrode. When the applied voltage of the gate is set to 0, or a negative voltage is applied, the element is turn on. A circuit that controls the voltage to be applied is referred to as a gate driver, and is connected to a gate electrode of the IGBT via a gate wiring.

The gate wiring is connected to the gate driver and the IGBT by a connector, a screw, or the like. However, in the case of a power conversion device for an electric vehicle, a railway vehicle, or the like, a problem such as a disconnection of the wiring may occur due to vibration or the like during traveling.

When the gate electrode floats in a state where the IGBT is turned off, that is, in a state where a high voltage is applied between a collector and an emitter which are the main terminals, the applied voltage of the gate electrode is 0 or negative, and no current flows between the main terminals (collector and emitter) of the IGBT, a leakage current flows into the gate via a parasitic capacitance (feedback capacitance) between the collector and the gate of the IGBT, and the gate voltage is increased. Thus, the IGBT is erroneously turned on.

When an element that is to be originally turned off is erroneously turned on, an overcurrent flows in the element due to an operation such as a short circuit of a power supply, and the element is broken. PTL 1 discloses a technique for detecting such a disconnection of the gate wiring. In PTL 1, the abnormality of a gate wiring is detected in a manner that a portion of the main current of the IGBT is divided, the divided current is caused to flow to a resistor for detection, and a phase difference between a gate command output from a gate driver and a voltage generated in the resistor is compared.

PTL 2 discloses a drive circuit for a power semiconductor element including: a control command unit that outputs a turn-on command for a power semiconductor element; a gate voltage detection unit that detects a gate voltage applied to a gate terminal after the control command unit outputs the turn-on command; a differentiator that subjects the gate voltage detected by the gate voltage detection unit to time differentiation; and a determination unit that determines, based on the gate voltage detected by the gate voltage detection unit and a differential value by the differentiator, whether the power semiconductor element is in a short-circuit state or not.

PTL 3 discloses a short-circuit protection circuit for a self-arc-extinguishing type semiconductor element including a first protection circuit and a second protection circuit. The first protection circuit is configured to reduce a voltage between a control electrode and a first main electrode of the self-arc-extinguishing type semiconductor element when detecting overcurrent flowing between the first main electrode and a second main electrode. The second protection circuit is configured to: detect current flowing in an interconnection adapted to supply the drive voltage; determine, based on the detected current, whether the first protection circuit is in an operating state; and change the drive voltage to turn off the self-arc-extinguishing type semiconductor element when the first protection circuit is in the operating state.

### Citation List

### Patent Literature

PTL 1: JP 2014-215234 A
PTL 2: DE 2018 003834 T5
PTL 3: US 2017/288385 A1

### Summary of Invention

### Technical Problem

However, PTL 1 described above has the following problems. The IGBT having a structure for dividing the portion of the main current is required in PTL 1, as described above, but a power IGBT that is generally used and has a high withstand voltage does not have such a function, and it is not possible to apply the configuration in PTL 1.

In addition, PTL 1 discloses a method using a current sensor that detects a current flowing through a booster circuit as another configuration, but there are problems that a current sensor having a large diameter is required in a high-power power conversion device, and thus a device is increased in size. The present invention has been made to solve the above problems, and an object of the present invention is to provide a simple fault detection device that detects a connection abnormality of a control line that controls a voltage-driven element and outputs an abnormality detection signal to improve reliability of an application facility.

### Solution to Problem

To solve the above problems, according to the present invention, there is provided a fault detection device as set forth in claim 1.

### Advantageous Effects of Invention

According to the present invention, it is possible to provide a simple fault detection device capable of improving the reliability of an application facility by detecting a connection abnormality of a control line that controls a voltage-driven element and outputting an abnormality detection signal.

### Brief Description of Drawings

[FIG. 1] FIG. 1 is a functional block diagram of a fault detection device according to Embodiment 1 of the present invention.
[FIG. 2] FIG. 2 is a functional block diagram of a fault detection device according to Embodiment 2 of the present invention.
[FIG. 3] FIG. 3 is a functional block diagram of a fault detection device according to Embodiment 3 of the present invention.
[FIG. 4] FIG. 4 is a functional block diagram of a fault detection device according to Embodiment 4 of the present invention.
[FIG. 5] FIG. 5 is a timing chart illustrating an operation when a gate wiring is not disconnected in the fault detection device in FIG. 1.
[FIG. 6] FIG. 6 is a timing chart illustrating an operation when the gate wiring is disconnected in the fault detection device in FIG. 1.
[FIG. 7] FIG. 7 is a timing chart illustrating an operation when a delay time of a delay circuit is shorter than a delay time in a state illustrated in FIG. 5 in the fault detection device in FIG. 1.
[FIG. 8] FIG. 8 is a timing chart illustrating an operation of the fault detection device in FIG. 3.

### Description of Embodiments

### [Embodiment 1]

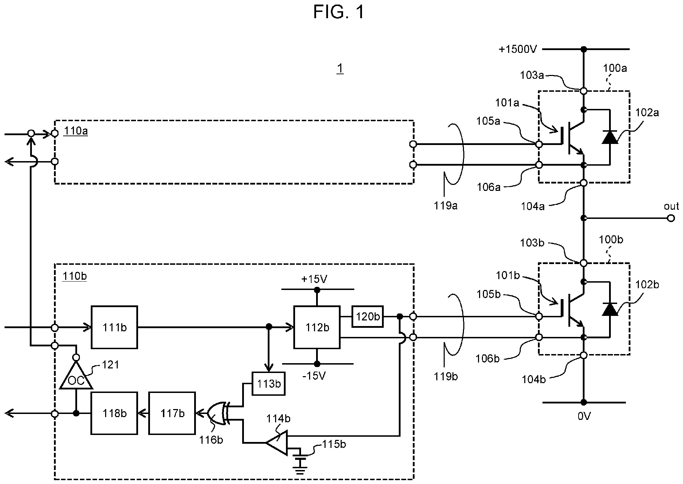

A fault detection device 1 according to Embodiment 1 of the present invention will be described with reference to FIG. 1. FIG. 1 is a functional block diagram of a fault detection device 1 according to Embodiment 1 of the present invention. In other words, it can be said that a partial circuit of an inverter configured by using an IGBT module is illustrated as the fault detection device 1 in FIG. 1. As illustrated in FIG. 1, the inverter includes two IGBT modules 100a and 100b connected in series between a positive power supply (+1500 V in Embodiment 1) and a negative power supply (0 V in Embodiment 1).

IGBTs 101a and 101b as the main components of the IGBT modules 100a and 100b are also collectively referred to as a semiconductor switching element 101 below. The "two IGBT modules 100a and 100b" in such an inverter configuration is commonly referred to as an "upper arm and a lower arm". The inverter is a circuit that outputs a desired voltage, current, and power to a load output terminal by the IGBTs of the upper arm and the lower arm operating in a predetermined order.

In the case of a general inverter, a so-called three-phase inverter configuration in which three inverters are connected in parallel with the configuration illustrated in FIG. 1 as a unit is often adopted. In FIG. 1, a component related to the upper arm is denoted by a reference sign with a suffix a, and a component related to the lower arm is denoted by a reference sign with a suffix b.

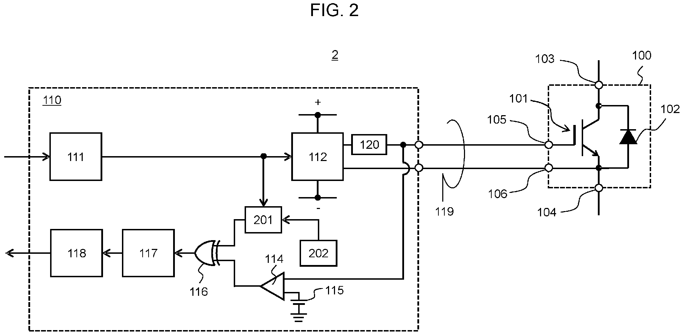

Note that, as will be described later with reference to FIGS. 2 to 4, and also in FIG. 1, when it is not necessary to distinguish the upper and lower arms from each other, each component will be described with reference signs without suffixes a and b. The reference sign 100 in FIGS. 1 to 4 denotes an IGBT module, and the IGBT module is configured by housing the IGBT 101 and a freewheel diode 102 in a package formed of resin or the like.

The IGBT module 100 includes a collector terminal 103 and an emitter terminal 104 through which a main current flows. The IGBT module 100 includes a gate terminal 105 and an auxiliary emitter terminal 106, and can control a current flowing between the collector terminal 103 and the emitter terminal 104 by controlling a voltage applied between the gate terminal 105 and the auxiliary emitter terminal 106.

Specifically, when a voltage equal to or higher than a threshold voltage Ref.V of the IGBT is applied to the gate terminal 105 with respect to the auxiliary emitter terminal 106, the IGBT 101 is turned on. On the other hand, when the voltage of the gate terminal 105 with respect to the auxiliary emitter terminal 106 is set to be equal to or lower than the threshold voltage Ref.V, the IGBT 101 is turned off. In general, in the case of an IGBT having a high withstand voltage exceeding 1 kV, in many cases, the threshold voltage Ref.V is about 4 to 7 V, +15 V is applied at the time of ON and -15 V is applied at the time of OFF in consideration of a margin such as an erroneous operation due to noise and fluctuation of the power supply.

A control unit (also referred to as a "gate driver" below) 110 applies a voltage for controlling the IGBT as described above, between the gate terminal 105 and the auxiliary emitter terminal 106 of the IGBT module 100. Although not illustrated, the gate driver 110 includes a signal input circuit 111 that receives an on/off command from a host controller that generates a PWM control signal of a converter and the like, and a drive circuit 112 that receives an output of the signal input circuit 111 and generates a control voltage of the IGBT.

In a conversion circuit with a high voltage exceeding 1 kV, it is necessary to provide insulation between a host controller and a gate driver. For example, a system in which the host controller and the gate driver are connected to each other by an optical fiber to perform communication in an electrically insulated state.

At this time, the signal input circuit 111 has a role of receiving an optical signal and converting the optical signal into an electric signal to the drive circuit 112. In addition to the system of performing communication by the optical fiber, there is also a configuration in which communication with the host controller is performed by an electrical signal, and a highly-insulated photocoupler is mounted in the signal input circuit 111 to secure the insulation between the input unit and the output unit of the input circuit 111.

The drive circuit 112 is a circuit that receives an electric signal from the signal input circuit 111 and outputs a voltage for controlling the gate of the IGBT module 100 via a gate resistor 120. The output of the signal input circuit 111 is often configured with a voltage at the TTL or CMOS level, and it is not possible to directly control the IGBT module 100 with the output of the signal input circuit 111. Therefore, the drive circuit 112 amplifies the output signal of the signal input circuit 111 to +15 V, -15 V, or the like to drive the IGBT.

Therefore, the drive circuit 112 is connected to a positive power supply (+15 V or the like) and a negative power supply (-15 V). The gate resistor 120 is provided to adjust a rate of change of the voltage applied to the gate terminal 105. When the resistance value is increased, the change in the gate voltage becomes gentle, and the switching speed of the IGBT 101 can be reduced.

The characteristic of Embodiment 1 is to detect the disconnection of the gate wiring 119 by using the output of the signal input circuit 111 and the output of the drive circuit 112. The gate voltage determination circuit 114 monitors the output of the gate drive circuit 112 at a node on an output-side node of the gate resistor 120. The gate voltage determination circuit 114 determines that the IGBT module 100 is turned on when the voltage becomes higher than a reference voltage 115, and determines that the IGBT module 100 is turned off when the voltage becomes lower than the reference voltage 115. Then, the gate voltage determination circuit 114 transmits the determination result to the XOR circuit 116. Meanwhile, the output of the signal input circuit 111 is also input to the delay circuit 113, and a signal is output to the XOR circuit 116 after a predetermined delay time.

The XOR circuit 116 performs exclusive OR of the output of the delay circuit 113 and the output of the gate voltage determination circuit 114, and transmits the result to a filter circuit 117. When the output of the XOR circuit 116 does not last for a predetermined time (that is, in a case of a short output), the filter circuit 117 excludes the output. As the predetermined time, for example, about several hundred ns to 2 µs is set. As a result, the filter circuit 117 exerts an erroneous operation function described later.

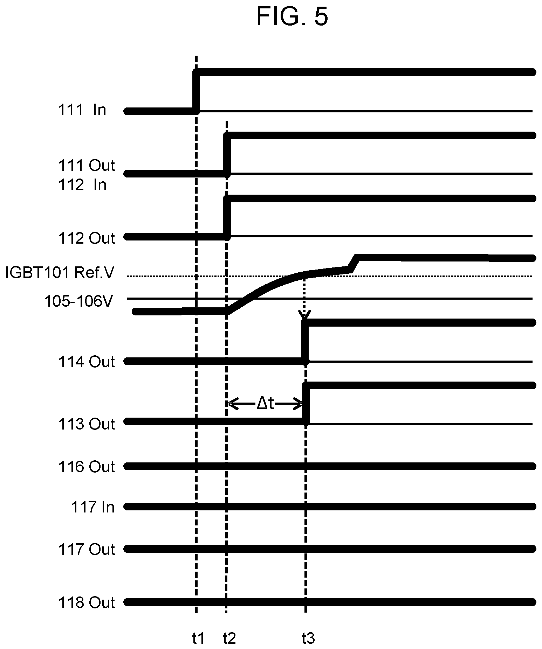

A feedback output circuit 118 is a circuit that receives the output of the filter circuit 117 and returns a signal to the host controller (not illustrated) described above. As described above, the feedback circuit functions to convert an electric signal into an optical signal and return a signal by an optical fiber. Next, the operation of the circuit in FIG. 1 will be described with reference to FIGS. 5 to 7.

FIG. 5 is a timing chart illustrating an operation when a gate wiring 119b is not disconnected in the fault detection device 1 in FIG. 1. When an on command is input from the host controller to the signal input circuit 111 at a time point t1, an input 111 In of the signal input circuit 111 is inverted from a low level to a high level.

Then, at a time point t2, an output 111 Out of the signal input circuit 111 is inverted from a level low to a high level. The reason why the time difference from the time point t1 to the time point t2 occurs is to perform processing such as conversion of an optical signal into an electrical signal in the signal input circuit 111 as described above.

The output of the signal input circuit 111 is input to the drive circuit 112, and the output of the drive circuit 112 is inverted from a low level to a high level at the time point t2 to increase the gate-emitter voltage (voltage between the gate terminal 105 and the auxiliary emitter terminal 106) of the IGBT module 100.

An input capacitance Cies (may be referred to as a "parasitic capacitance" or a "feedback capacitance") due to the structure of the element exists between the gate and the emitter of the IGBT module 100. Even though the output of the drive circuit 112 is inverted from a low level to a high level, the gate-emitter voltage is not immediately inverted to the high level, and increases by an operation of a CR charging circuit of the input capacitance Cies and the gate resistor 120. The increase time is about several hundred ns to 5 µs in the case of an IGBT having a high withstand voltage exceeding 1 kV.

When the gate-emitter voltage exceeds the threshold voltage Ref.V of the IGBT 101 at a time point t3, the gate voltage determination circuit 114 determines that the IGBT 101 is turned on and inverts the output from a low level to a high level. In this case, the reference voltage 115 is set to the threshold voltage Ref.V of the IGBT 101. The output of the gate voltage determination circuit 114 is input to the XOR circuit 116. On the other hand, the output of the signal input circuit 111 is also input to the delay circuit 113, and the output signal is inverted from a low level to a high level at the time point t3 after a predetermined time Δt1 elapses.

The output of the delay circuit 113 is input to the XOR circuit 116. The delay time Δt1 of the delay circuit 113 is set to be the same as the time from when the output 111 Out of the signal input circuit 111 is inverted until the gate-emitter voltage of the IGBT module 100 reaches the threshold voltage Ref.V. Examples of the configuration of the delay circuit include a circuit in which a CR charging circuit in which a capacitor and a resistor are combined is connected in series in multiple stages.

The XOR circuit 116 calculates the exclusive OR of a signal 113 Out from the delay circuit 113 and a signal 114 Out from the gate voltage determination circuit 114 to generate an output 116 Out. Therefore, as illustrated in FIG. 5, since both inputs are low until the time point t3, the output 116 Out is also low. In addition, since both the inputs are simultaneously high after the time point t3, the output 116 Out maintains low. Therefore, since a signal 118 Out of the feedback output circuit 118 that operates in response to the output 116 Out of the XOR circuit 116 is not inverted and the signal 118 Out is low, the connection state of the gate wiring 119 is determined to be normal.

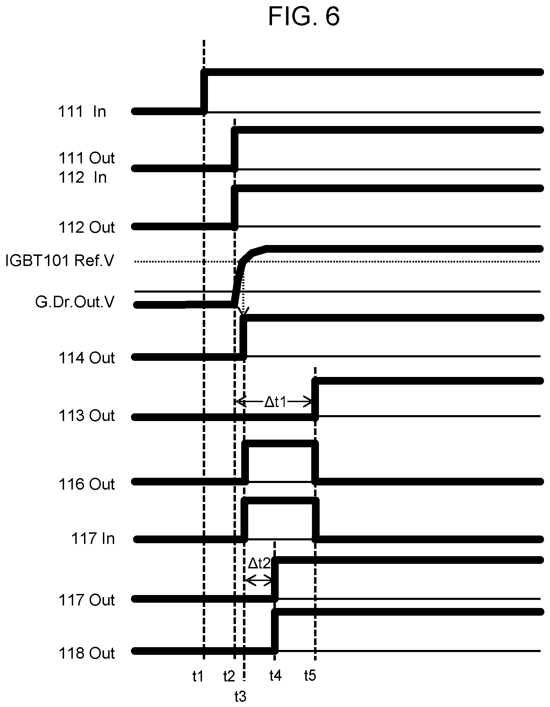

Next, a case where the gate wiring 119 is disconnected will be described with reference to FIG. 6. FIG. 6 is a timing chart illustrating an operation when the gate wiring 119 is disconnected in the fault detection device 1 in FIG. 1. A signal is input from the host controller to the signal input circuit 111 at a time point t1. An output 111 Out of the signal input circuit 111 is inverted from a low level to a high level at a time point t2, and an input 112 In and an output 112 Out of the drive circuit 112 are also inverted from a low level to a high level. At the same time, an output voltage G.Dr.Out.V of the gate driver 110 also increases.

The difference from FIG. 5 is that the output of the gate driver 110 is in an open state because the gate wiring 119 is disconnected, and the voltage rapidly increases because there is no capacitance of the gate to be charged. Therefore, only an output 114 Out of the gate voltage determination circuit 114 is inverted at a time point t3 before a time point t5 at which the output of the delay circuit 113 is inverted. When only one input is inverted, the XOR circuit 116 inverts an output 116 Out from a low level to a high level.

The inverted output 116 Out of the XOR circuit 116 is input to the filter circuit 117, and the filter circuit 117 inverts an output 117 Out from a low level to a high level after a delay time Δt2. The delay time Δt2 is a time constant of the filter and is determined from the viewpoint of preventing an erroneous operation to be described later.

When the output of the filter circuit 117 changes from a low level to a high level, an output 118 Out of the feedback output circuit 118 is inverted from a low level to a high level, and the host controller is notified of the disconnection. When an output 113 Out of the delay circuit 113 is inverted from a low level to a high level at a time point t5 after a delay time Δt1, the output 116 Out of the XOR circuit 116 is inverted to the low level again, and the input 117 In of the filter circuit 117 is also inverted to the low level.

In this case, by providing the filter circuit 117 with a latch function, even though the input 117 In is inverted to be low as illustrated in FIG. 6, the output 117 Out can be held to be high, and the host controller can be continuously notified of the disconnection. Note that a configuration in which the feedback output circuit 118 is provided with a latch function without providing the filter circuit 117 with the latch function as in Embodiment 1 or a configuration in which the host controller has a function of holding an abnormality is also conceivable.

Note that, in Embodiment 1, the output of the feedback output circuit 118b of the lower arm is connected to the input of the gate driver 110a of the upper arm via the inverter 121 having the open collector, and when disconnection is detected, the ON command from the host controller input to the gate driver 110a of the upper arm is stopped.

In the case of the inverter configuration illustrated in FIG. 1, when the upper arm is erroneously turned on while the gate wiring of the lower arm is disconnected and turned on, the IGBTs of the upper arm and the lower arm are simultaneously turned on to short-circuit the power supply of +1500 V to 0 **V.** When the power supply is short-circuited, an overcurrent of several tens of thousands A flows, which damages not only the IGBT but also the entire system.

Therefore, when the disconnection is detected, the command of the pair of arms is rapidly turned off to protect the system. At the same time, it is preferable to notify the host controller of the disconnection so as to stop the entire system.

As described above, according to Embodiment 1, there are advantages that, when the gate wiring 119 is disconnected, it is possible to detect the disconnection by monitoring the timing of the increase in the gate voltage, and it is possible to easily detect the disconnection with a simple configuration.

Next, the erroneous operation prevention function of the filter circuit 117 will be described. The change in the gate voltage of the IGBT has fluctuation due to manufacturing variations of the IGBT, and the gate-emitter voltage does not necessarily reach the threshold value in the same time in all the IGBTs. This time also varies depending on the temperature.

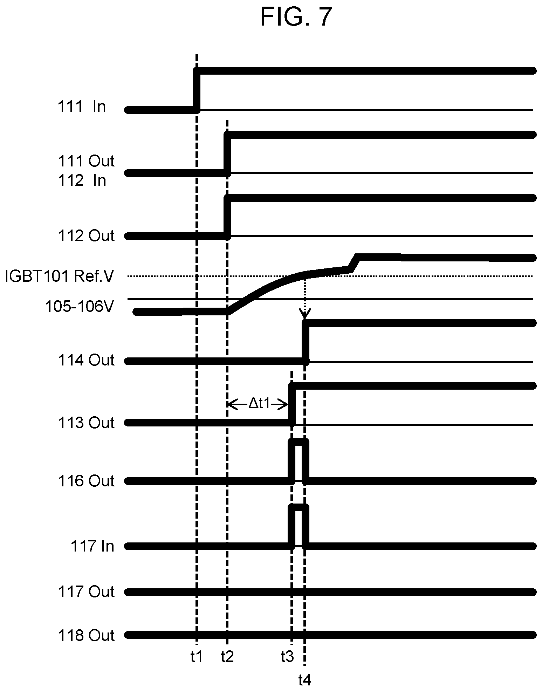

Furthermore, the circuit operation of the delay circuit 113 also has operation fluctuation due to manufacturing variations of components to be used and the temperature of the use environment. When the fluctuation exists, the delay time Δt1 by the delay circuit 113 may not coincide with the time until the output voltage 105-106 V of the gate driver 110 reaches the threshold voltage Ref.V of the IGBT 101. This will be described with reference to FIG. 7.

FIG. 7 is a timing chart illustrating an operation when the delay time Δt1 of the delay circuit 113 is shorter than a delay time in a state illustrated in FIG. 5 in the fault detection device 1 in FIG. 1. FIG. 7 illustrates a case where the delay time Δt1 of the delay circuit 113 is shorter than the delay time in FIG. 5 due to variations in the characteristics of the IGBT described above. Therefore, the output of the delay circuit 113 is inverted earlier than inversion of the output of the gate voltage determination circuit 114, the output 116 Out of the XOR circuit 116 is inverted at a time point t3, and the input 117 In of the filter circuit 117 is also inverted from a low level to a high level.

Then, at a time point t4, the gate-emitter voltage 105-106 V of the IGBT module 100 increases to reach the threshold voltage Ref.V, and the output 114 Out of the gate voltage determination circuit 114 is inverted from a low level to a high level. When such inversion is performed as described above, the output 116 Out of the XOR circuit 116 is inverted to be low again, and the input 117 In of the filter circuit 117 is also inverted from a high level to a low level.

When the period from the time point t3 to a time point t4 is shorter than the filter time constant of the filter circuit 117, the output 117 Out of the filter circuit 117 is not inverted from a low level to a high level, and the output 118 Out of the feedback output circuit 118 does not change. Since the fluctuation of the pulse due to the manufacturing variation of the component or the temperature change necessarily occurs, it is possible to reliably prevent an erroneous detection due to the fluctuation by appropriately setting the filter time constant of the filter circuit 117.

### [Embodiment 2]

FIG. 2 is a functional block diagram of a fault detection device 2 according to Embodiment 2 of the present invention. In FIG. 2, the same components as those in FIG. 1 are denoted by the same reference signs. Although only the lower arm of FIG. 1 is illustrated in FIG. 2, the operation and effect as the inverter are the same as those in FIG. 1. In FIG. 2, the reference sign 201 denotes a timing determination circuit, and the reference sign 202 denotes a timer circuit.

The characteristic of Embodiment 2 is to perform abnormality determination with high accuracy by using the timer circuit 202. The timer circuit 202 includes a clock and an arithmetic circuit, and can realize a function of changing a delay time based on information from a temperature sensor or the like although not illustrated. This makes it possible to detect the disconnection of the wiring without erroneously detecting the fluctuation in the delay time.

### [Embodiment 3]

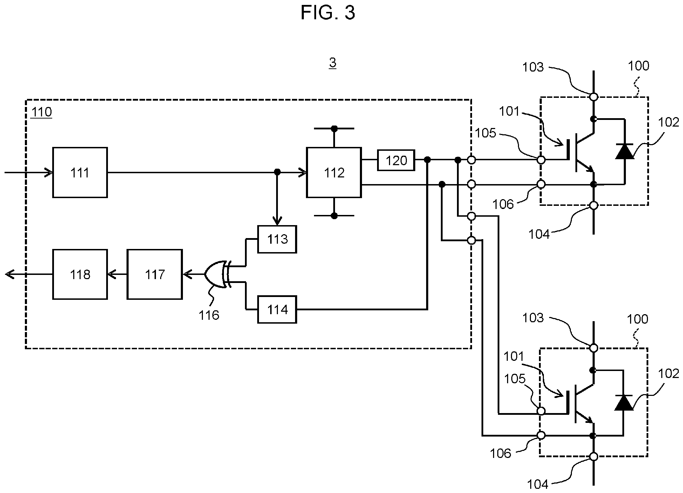

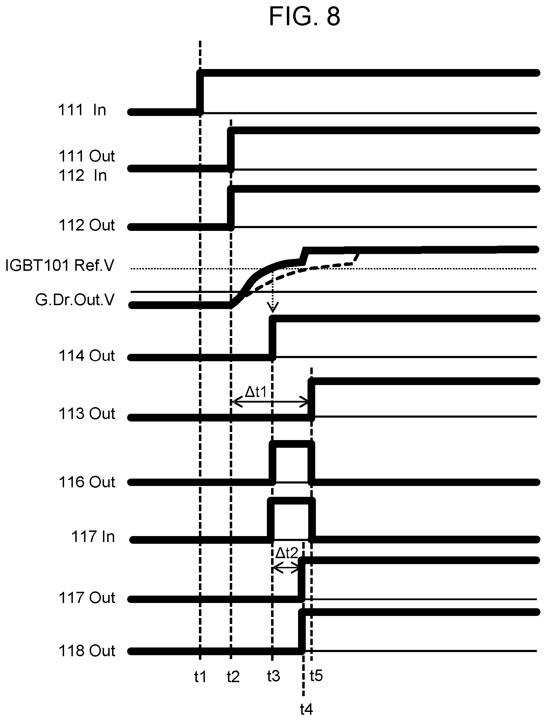

Next, Embodiment 3 will be described with reference to FIGS. 3 and 8. FIG. 3 is a functional block diagram of a fault detection device 3 according to Embodiment 3 of the present invention. In addition, FIG. 8 is a timing chart illustrating the operation of the fault detection device 3 illustrated in FIG. 3. In FIG. 3, the same components as those in FIGS. 1 and 2 are denoted by the same reference signs. The fault detection device 3 is characterized in that it is possible to detect the disconnection of the gate wirings of the IGBTs 101 driven in parallel. The IGBTs 101 driven in parallel have the same characteristics and increase the current capacity by being controlled to be turned on and off at the same timing.

FIG. 3 illustrates a case where the fault detection device 3 has a configuration in which wirings branched into two pieces from one gate driver 110 are connected to two gate terminals 105 of the respective IGBTs 101 connected in parallel. More specifically, the drive circuit 112 provided in the gate driver 110 generates a control signal and applies the control signal to the two gate terminals 105 via one gate resistor 120.

Therefore, the gate wiring branched after the gate resistor 120 is connected to the gate terminal 105. In this configuration, when one gate wiring is disconnected, only the gate of the other IGBT is charged and discharged. In the case of the fault detection device 3 illustrated in FIG. 3, since the input capacitance of the element as viewed from the gate driver 110 is reduced to 1/2, the change in the gate voltage is faster than that at the normal time.

The operation of the fault detection device 3 illustrated in FIG. 3 will be described with reference to FIG. 8. The voltage waveform when there is no disconnection is as indicated by a broken line in the output voltage G.DrOut.V of the gate driver 110 after the increase is started at a time point t2 in FIG. 8. On the other hand, when the gate wiring in one of the two parallel IGBTs 101 in the fault detection device 3 is disconnected, the output voltage G.Dr.Out.V increases in about 1/2 of the time as compared to the voltage waveform when there is no disconnection. Then, at a time point t3, the output 114 Out of the gate voltage determination circuit 114 is inverted, and the output 116 Out of the XOR circuit 116 and the input 117 In of the filter circuit 117 are also inverted to be high.

The output 117 Out of the filter circuit 117 is inverted to be high after the delay time Δt2 of the filter circuit has elapsed, and the output 118 Out of the feedback output circuit 118 is inverted to be high. Embodiment 3 provides a method for detecting the disconnection of the gate wiring without increasing the number of circuit elements of the gate voltage determination circuit 114 or the like even though IGBTs are connected in parallel in this manner.

### [Embodiment 4]

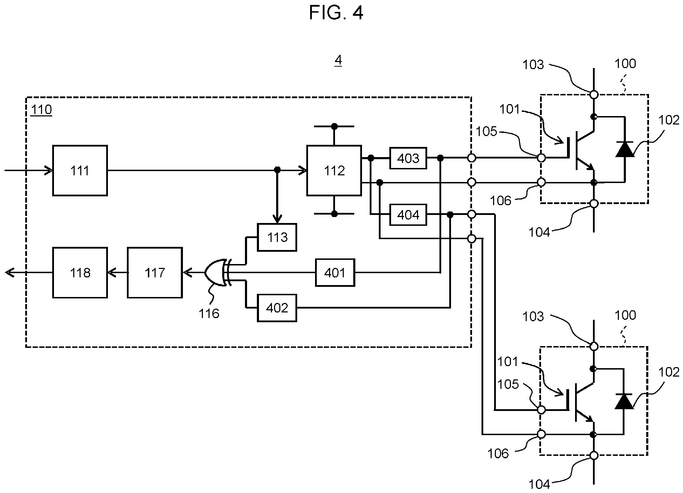

FIG. 4 is a functional block diagram of a fault detection device 4 according to Embodiment 4 of the present invention. In FIG. 4, the same components as those in FIGS. 1 to 3 are denoted by the same reference signs. In FIG. 4, the reference signs 401 and 402 denote a gate voltage determination circuit, and the reference signs 403 and 404 denote a gate resistor. The fault detection device 4 is characterized in that the gate voltage determination circuit 114 illustrated in FIGS. 1 to 3 is provided in each of IGBTs as indicated by the reference signs 401 and 402 in FIG. 4, and is configured to perform determination individually.

In Embodiment 3, the configuration in which one gate voltage determination circuit 114 detects the disconnection of the gate wirings of the plurality of IGBTs has been described. In the configuration in Embodiment 3, the sensitivity of the disconnection detection decreases in accordance with the increased number of parallel IGBT elements. When the number of parallels increases, that is, for example, four IGBT elements are arranged in parallel, even though one gate wiring is disconnected, the total input capacitance of the IGBT elements as viewed from the gate driver 110 is reduced to only 3/4, and the rising edge of the output voltage of the gate driver in FIG. 8 is not significantly different from the normal case.

Therefore, when the number of the IGBT elements in parallel is further increased, the sensitivity of detection is decreased. Thus, it is difficult to detect the disconnection. In Embodiment 4, the same number of gate resistors 403 and 404 and the same number of gate voltage determination circuits 401 and 402 as the number of parallel IGBT elements are provided, and the potentials of the output-side node of the gate resistors 403 and 404 are monitored. In this manner, a decrease in detection sensitivity when the number of parallels is increased is prevented. With this configuration, the fault detection device 4 according to Embodiment 4 can detect that only the voltage of the disconnected gate wiring rapidly increases. As a result, the fault detection device 4 can detect the disconnection of the gate wiring without decreasing the detection sensitivity.

Hitherto, the IGBT has been described above as an example of the element to be driven. It is apparent that a similar effect can be obtained as long as the element is a voltage-driven element such as a MOSFET or a junction field effect transistor (JFET). Further, in Embodiment 1, the configuration of blocking the damage in the system by turning off the gate command of the pair of elements when the disconnection is detected has been described. As another method, a similar protection effect can be obtained by a method of turning off the main power supply of the system.

### <Supplement>

In the inverter, an IGBT that turns on/off a high voltage such as 1 kV and a gate drive circuit including a logic for low-voltage driving are disposed at a distance of a considerable length for safety. Therefore, the gate wirings 119b connecting the IGBT and the gate drive circuit are wired with a length corresponding to the separation distance. In an operation process until the gate wiring 119b is completed, it is also necessary to consider the probability of a wiring defect caused by the operation quality.

Due to the above circumstances, it is necessary to assume a fault in which the gate wiring 119 is disconnected. When the gate wiring 119 is disconnected, a low gate voltage is not guaranteed due to a parasitic capacitance between the collector and the gate or the like, and a problem occurs that the IGBT is turned on when the IGBT is originally turned off.

In the fault detection devices 1 to 4 according to the embodiments of the present invention, the time required for the gate voltage to rise is shorter than the time of the transient phenomenon determined by the time constant of the capacitance component in the IGBT at the time of gate disconnection than at the normal time. Therefore, the rising of the gate voltage is steeper than the transient phenomenon in the normal state.

The fault detection devices 1 to 4 detects that a difference has occurred, by comparing the threshold value with a gate voltage rising to some extent for the rising speed of the gate voltage corresponding to the normal time and the gate disconnection time. In other words, when the rate of change of the output voltage of the control unit (gate driver) 110 is greater than the prescribed value, it is determined that the connection abnormality has occurred in the control line 119, and the abnormality detection signal is output.

As described above, according to the present invention, it is possible to provide a fault detection device and a fault detection method capable of detecting disconnection of a gate wiring of a voltage-driven power semiconductor element used in a power conversion device with high reliability and a simple configuration. According to the present invention, it is possible to reliably detect the disconnection of the gate wiring by a simple method of monitoring the output voltage of the gate driver without using an IGBT or the like having a special structure for current detection.

Next, the fault detection devices (present devices) 1 to 3 according to the embodiments of the present invention will be summarized.
[1] The present devices 1 to 3 are the present device 1 that detects whether the connection state is normal or abnormal for the control line 119 electrically connecting the auxiliary terminals 105 and 106 for controlling the paths related to the main terminals 103 and 104 of the semiconductor switching element 101, and the control unit 110 that controls driving of the semiconductor switching element 101. When the rate of change of the output voltage output from the control unit 110 to the control line 119 is greater than the prescribed value, the present devices 1 to 3 determine that the connection abnormality has occurred in the control line 119 and outputs the abnormality detection signal.
   The semiconductor switching element 101 provided in the present devices 1 to 3 is a voltage-driven element. The present devices 1 to 3 detect the connection abnormality of the control line 119 that controls the voltage-driven element and outputs the abnormality detection signal. In this manner, it is possible to easily improve the reliability of the inverter or the like that is the application facility.
[2] The present devices 1 to 3 are suitable for a power conversion circuit (inverter). The power conversion circuit is configured such that the main terminals 103 and 104 opened and closed respectively by a plurality of arms 101a and 100b formed for each semiconductor switching element 100 are connected in series between a pair of power supply lines. The control unit 110 is the gate driver 110 that applies a control signal to the auxiliary terminals 105 and 106. The control line 119 is the gate wiring 119 that connects the auxiliary terminals 105 and 106 with the output terminal of the gate driver 110.
[3] At least one of the pair of arms 100a and 100b that constitutes the power conversion circuit and are connected in series is controlled to be turned off by the gate driver 110. When the abnormality detection signal is acquired due to the occurrence of the connection abnormality in one arm 100a(b) of the pair of arms 100a and 100b, the abnormality detection signal is input to the gate driver 110 connected to the other arm 100b(a) to stop the gate driver 110 to which the abnormality detection signal is input.

When at least one of the pair of arms 100a and 100b connected in series is controlled to be turned off, the power conversion circuit is substantially stopped, and safety can be secured. At this time, even though the arm 100 on the side where the connection abnormality has occurred cannot be turned off, the arm on the normal side can be turned off.

[4] The abnormality detection signal may be transmitted to the host controller that gives a command to the gate driver 110 to stop the power conversion circuit. In [3], safety can be ensured only by turning off the arm 100 on the side where the connection abnormality does not occur out of the pair of arms 100a and 100b. In addition, the safety is further ensured by stopping the entire power conversion circuit, that is, the main power supply of the system.

[5] The arm 100 includes a semiconductor switching element 101, a pair of main terminal pairs including the main terminals 103,104 of the semiconductor switching element 101, and a pair of auxiliary terminal pairs for controlling a current flowing through the main terminal pairs. The gate driver 110 includes a drive circuit 112, a gate voltage determination circuit 114, a delay circuit 113, and an XOR circuit 116.

The drive circuit 112 receives a command from the host controller that gives a command to the gate driver 110 and generates a control signal. The gate voltage determination circuit 114 outputs the comparison determination signal 114 Out when the output voltage of the drive circuit 112 exceeds the predetermined voltage. The delay circuit 113 receives a command from the controller and performs delay for a predetermined time, and then outputs the delay signal 113 Out. The XOR circuit 116 outputs an exclusive OR with respect to the outputs of the delay circuit 113 and the gate voltage determination circuit 114.

When the signal from the gate voltage determination circuit 114 is input earlier than the output of the delay circuit 113, the abnormality detection signal is generated based on the output signal of the XOR circuit 116. As a result, it is possible to detect that the gate voltage rises rapidly.

[6] When the abnormality detection signal is acquired due to the occurrence of the connection abnormality in one arm 100 side of the pair of arms 100a and 100b, the acquired abnormality detection signal is input to the gate driver 110 connected to the other arm 100 to stop the gate driver 110 to which the acquired abnormality detection signal is input. At this time, even though the arm 100 on the side where the connection abnormality has occurred cannot be turned off, the arm on the normal side can be turned off.

[7] The abnormality detection signal is transmitted to the host controller that gives a command to the gate driver 110 to stop the power conversion circuit. As a result, since the entire power conversion circuit is stopped, safety is further ensured.

### Reference Signs List

100, 100a, 100b IGBT module (upper arm, lower arm)
100, 101a, 101b IGBT (semiconductor switching element)
102, 102a, 102b freewheel diode
103, 103a, 103b collector terminal
104, 104a, 104b emitter terminal
105, 105a, 105b gate terminal
106, 106a, 106b auxiliary emitter terminal
110, 110a, 110b gate driver
111, 111b signal input circuit
112, 112b drive circuit
113, 113b delay circuit
114, 114b, 401, 402 gate voltage determination circuit
115, 115b reference voltage
116, 116b XOR circuit
117, 117b filter circuit-
118, 118b feedback output circuit
119, 119a, 119b gate wiring
120, 120b, 403, 404 gate resistor
201 timing determination circuit
202 timer circuit

## Claims

1. A fault detection device (1, 2, 3, 4) configured to detect whether a connection state is normal or abnormal for a control line (119), which performs an electrical connection between an auxiliary terminal (105, 106) for controlling a path for a main terminal (103, 104) of a semiconductor switching element (101) and a control unit (110) that controls driving of the semiconductor switching element (101),
wherein, the fault detection device (1, 2, 3, 4) is configured so that when a rate of change of an output voltage output from the control unit (110) to the control line (119) is greater than a prescribed value, it is determined that a connection abnormality has occurred in the control line (119), and an abnormality detection signal is output,
an arm (100) is formed for the semiconductor switching element (101),
the arm (100) includes
the semiconductor switching element (101),
a pair of main terminal pairs (103, 104) configured by main terminals of the semiconductor switching element, and
a pair of an auxiliary terminal pairs (105, 106) that control a current flowing in the main terminal pair,
a power conversion circuit is configured by connecting main terminals (103, 104) of a plurality of arms in series between a pair of power supply lines, the main terminals (103, 104) being respectively opened and closed by a plurality of the arms (100),
the control unit (110) is a gate driver that is configured to apply a control signal to the auxiliary terminal,
the control line is a gate wiring that connects the auxiliary terminal (105) and an output terminal of the gate driver (110),
the gate driver (110) includes
a drive circuit (112) that is configured to receive a command from a host controller that gives a command to the gate driver (110) and generate the control signal,
a gate voltage determination circuit (114, 401, 402) that is configured to output a comparison determination signal when an output voltage of the drive circuit (112) exceeds a predetermined voltage,
**characterized in that**
the gate driver (110) includes a delay circuit (113) that is configured to receive a command from the controller and generate an output after a delay of a predetermined time, and
the gate driver (110) includes an XOR circuit (116) that is configured to output an exclusive OR with respect to outputs of the delay circuit (113) and the gate voltage determination circuit (114, 401, 402), and
the gate driver (110) is configured to generate an abnormality detection signal based on an output signal of the XOR circuit (116) when the comparison determination signal output by the gate voltage determination circuit (114, 401, 402) is input earlier than a delay signal output by the delay circuit (113).

2. The fault detection device (1, 2, 3, 4) according to claim 1, wherein
when the abnormality detection signal is acquired due to an occurrence of the connection abnormality on one arm side of the pair of the arms (100), the acquired abnormality detection signal is input to the gate driver (110) connected to the other arm (100) to stop the gate driver (110) to which the acquired abnormality detection signal is input.

3. The fault detection device (1, 2, 3, 4) according to claim 1, wherein
the abnormality detection signal is transmitted to a host controller that gives a command to the gate driver (110) to stop the power conversion circuit.

4. A fault detection method for detecting whether a connection state is normal or abnormal for a control line (119), which performs an electrical connection between an auxiliary terminal (105, 106) for controlling a path for a main terminal (103, 104) of a semiconductor switching element (101) and a control unit (110) that controls driving of the semiconductor switching element (101), the method comprising:
when a rate of change of an output voltage output from the control unit (110) to the control line (119) is greater than a prescribed value, determining that a connection abnormality has occurred in the control line (119), and outputting an abnormality detection signal;
forming a power conversion circuit by connecting a plurality of arms (100) including the semiconductor switching elements (101) in series between a pair of power supply lines;
generating a control signal by the control unit (110) as a gate driver that controls opening and closing of a path for the main terminals (103, 104) of the semiconductor switching elements (101);
applying the control signal to the auxiliary terminal (105, 106) of the semiconductor switching element (101) via a gate wiring;
when the control line (119) is determined to have the connection abnormality during an operation of the power conversion circuit, determining that the gate wiring that connects an output terminal of the gate driver (110) and the auxiliary terminal (105, 106) is in a non-conductive state;
controlling a current flowing in a pair of main terminal pairs (103, 104) configured by the main terminals of the semiconductor switching elements (101) in the respective arms (100), by a pair of auxiliary terminal pairs (105, 106);
when a command is received from a host controller that gives a command to the gate driver (110), generating the control signal by a drive circuit (112);
when an output voltage of the drive circuit (112) exceeds a predetermined voltage, generating a comparison determination signal by a gate voltage determination circuit (114, 401, 402);
**characterized by** the method further comprising
generating a delay signal by a delay circuit (113) after a predetermined time is delayed from reception of the command from the controller;
outputting an exclusive OR with respect to output signals of the delay circuit (113) and the gate voltage determination circuit (114, 401, 402), by an XOR circuit (116); and
when the comparison determination signal from the gate voltage determination circuit (114, 401, 402) is input earlier than the delay signal of the delay circuit (113), generating an abnormality detection signal by an output signal of the XOR circuit (116).

5. The fault detection method according to claim 4, further comprising:
when the abnormality detection signal is acquired due to an occurrence of the connection abnormality in one arm (100) of the pair of the arms, inputting the acquired abnormality detection signal to the gate driver (110) connected to the other arm (100) to stop the gate driver (110) to which the acquired abnormality detection signal is input.

6. The fault detection method according to claim 4, further comprising:
transmitting the abnormality detection signal to a host controller that gives a command to the gate driver (110) to stop the power conversion circuit.

## Patentansprüche

1. Fehlerdetektionsvorrichtung (1, 2, 3, 4), die ausgelegt ist, um zu detektieren, ob ein Verbindungszustand für eine Steuerleitung (119), die eine elektrische Verbindung zwischen einem Hilfsanschluss (105, 106) zum Steuern eines Pfads für einen Hauptanschluss (103, 104) eines Halbleiterschaltelements (101) und einer Steuereinheit (110), die das Ansteuern des Halbleiterschaltelements (101) steuert, durchführt, normal oder abnormal ist,
wobei die Fehlerdetektionsvorrichtung (1, 2, 3, 4) so ausgelegt ist, dass, wenn eine Änderungsrate einer Ausgangsspannung, die aus der Steuereinheit (110) an die Steuerleitung (119) ausgegeben wird, größer als ein vorgeschriebener Wert ist, bestimmt wird, dass eine Verbindungsanomalie in der Steuerleitung (119) aufgetreten ist und ein Anomaliedetektionssignal ausgegeben wird,
wobei ein Zweig (100) für das Halbleiterschaltelement (101) ausgebildet ist,
wobei der Zweig (100) Folgendes umfasst:
das Halbleiterschaltelement (101),
ein Paar Hauptanschlusspaare (103, 104), die durch Hauptanschlüsse des Halbleiterschaltelements ausgelegt sind, und
ein Paar Hilfsanschlusspaare (105, 106), die einen Strom, der in dem Hauptanschlusspaar fließt, steuert,
wobei eine Leistungswandlerschaltung durch Verbinden von Hauptanschlüssen (103, 104) einer Vielzahl von Zweigen in Reihe zwischen einem Paar von Leistungsversorgungsleitungen ausgelegt ist, wobei die Hauptanschlüsse (103, 104) jeweils durch eine Vielzahl der Zweige (100) geöffnet und geschlossen werden,
wobei die Steuereinheit (110) ein Gate-Treiber ist, der ausgelegt ist, um ein Steuersignal an den Hilfsanschluss anzulegen,
wobei die Steuerleitung eine Gate-Verdrahtung ist, die den Hilfsanschluss (105) und einen Ausgangsanschluss des Gate-Treibers (110) verbindet,
wobei der Gate-Treiber (110) Folgendes umfasst:
eine Ansteuerungsschaltung (112), die ausgelegt ist, um einen Befehl von einer Host-Steuerung zu empfangen, die einen Befehl an den Gate-Treiber (110) ausgibt, und um ein Steuersignal zu erzeugen,
eine Gate-Spannungsbestimmungsschaltung (114, 401, 402), die ausgelegt ist, um ein Vergleichsbestimmungssignal auszugeben, wenn eine Ausgangsspannung der Ansteuerungsschaltung (112) eine vorbestimmte Spannung überschreitet,
**dadurch gekennzeichnet, dass**:
der Gate-Treiber (110) eine Verzögerungsschaltung (113) umfasst, die ausgelegt ist, um einen Befehl von der Steuerung zu empfangen und eine Ausgabe nach einer Verzögerung im Ausmaß einer vorbestimmten Zeit zu erzeugen, und
der Gate-Treiber (110) eine XOR-Schaltung (116) umfasst, die ausgelegt ist, um ein exklusives ODER in Bezug auf Ausgaben der Verzögerungsschaltung (113) und der Gate-Spannungsbestimmungsschaltung (114, 401, 402) auszugeben, und
der Gate-Treiber (110) ausgelegt ist, um ein Anomaliedetektionssignal basierend auf einem Ausgabesignal der XOR-Schaltung (116) zu erzeugen, wenn das Vergleichsbestimmungssignal, das durch die Gate-Spannungsbestimmungsschaltung (114, 401, 402) ausgegeben wird, früher eingegeben wird als ein Verzögerungssignal, das durch die Verzögerungsschaltung (113) ausgegeben wird.

2. Fehlerdetektionsvorrichtung (1, 2, 3, 4) nach Anspruch 1, wobei:
wenn das Anomaliedetektionssignal aufgrund eines Auftretens der Verbindungsanomalie an einer Zweigseite des Paars der Zweige (100) erfasst wird, das erfasste Anomaliedetektionssignal in den Gate-Treiber (110) eingegeben wird, der mit dem anderen Zweig (100) verbunden ist, um den Gate-Treiber (110), in den das erfasste Anomaliedetektionssignal eingegeben wurde, anzuhalten.

3. Fehlerdetektionsvorrichtung (1, 2, 3, 4), nach Anspruch 1, wobei:
das Anomaliedetektionssignal an eine Host-Steuerung gesendet wird, die einen Befehl an den Gate-Treiber (110) ausgibt, um die Leistungswandlerschaltung anzuhalten.

4. Fehlerdetektionsverfahren zum Detektieren, ob ein Verbindungszustand für eine Steuerleitung (119) normal oder abnormal ist, das eine elektrische Verbindung zwischen einem Hilfsanschluss (105, 106) zum Steuern eines Pfads für einen Hauptanschluss (103, 104) eines Halbleiterschaltelements (101) und einer Steuereinheit (110), die das Ansteuern des Halbleiterschaltelements (101) steuert, durchführt, wobei das Verfahren Folgendes umfasst:
wenn eine Änderungsrate einer Ausgangsspannung, die aus der Steuereinheit (110) an die Steuerleitung (119) ausgegeben wird, größer als ein vorgeschriebener Wert ist, Bestimmen, dass eine Verbindungsanomalie in der Steuerleitung (119) aufgetreten ist und Ausgeben eines Anomaliedetektionssignals;
Ausbilden einer Leistungswandlerschaltung durch Verbinden einer Vielzahl von Zweigen (100), umfassend die Halbleiterschaltelemente (101), in Reihe zwischen einem Paar von Leistungsversorgungsleitungen;
Erzeugen eines Steuersignals durch die Steuereinheit (110) als ein Gate-Treiber, der das Öffnen und Schließen eines Pfads für die Hauptanschlüsse (103, 104) der Halbleiterschaltelemente (101) steuert;
Anlegen des Steuersignals an den Hilfsanschluss (105, 106) des Halbleiterschaltelements (101) über eine Gate-Verdrahtung;
wenn bestimmt wird, dass die Steuerleitung (119) die Verbindungsanomalie während eines Betriebs der Leistungswandlerschaltung aufweist, Bestimmen, dass die Gate-Verdrahtung, die einen Ausgangsanschluss des Gate-Treibers (110) und den Hilfsanschluss (105, 106) verbindet, in einem nichtleitenden Zustand ist;
Steuern eines Stroms, der in einem Paar von Hauptanschlusspaaren (103, 104) fließt, die durch die Hauptanschlüsse der Halbleiterschaltelemente (101) in den entsprechenden Zweigen (100) ausgelegt sind, durch ein Paar von Hilfsanschlusspaaren (105, 106);
wenn ein Befehl von einer Host-Steuerung empfangen wird, die einen Befehl an den Gate-Treiber (110) ausgibt, Erzeugen des Steuersignals durch eine Ansteuerungsschaltung (112);
wenn eine Ausgangsspannung der Ansteuerungsschaltung (112) eine vorbestimmte Spannung übersteigt, Erzeugen eines Vergleichsbestimmungssignals durch eine Gate-Spannungsbestimmungsschaltung (114, 401, 402);
**dadurch gekennzeichnet, dass** das Verfahren ferner Folgendes umfasst:
Erzeugen eines Verzögerungssignals durch eine Verzögerungsschaltung (113), nachdem eine vorbestimmte Zeit ab dem Empfang des Befehls der Steuerung verzögert ist;
Ausgeben eines exklusiven ODER in Bezug auf Ausgangssignale der Verzögerungsschaltung (113) und der Gate-Spannungsbestimmungsschaltung (114, 401, 402) durch eine XOR-Schaltung (116); und
wenn das Vergleichsbestimmungssignal von der Gate-Spannungsbestimmungsschaltung (114, 401, 402) früher eingegeben wird als das Verzögerungssignal der Verzögerungsschaltung (113), Erzeugen eines Anomaliedetektionssignals durch ein Ausgangssignal der XOR-Schaltung (116).

5. Fehlerdetektionsverfahren nach Anspruch 4, das ferner Folgendes umfasst:
wenn das Anomaliedetektionssignal aufgrund eines Auftretens der Verbindungsanomalie in einem Zweig (100) des Paars der Zweige erfasst wird, Eingeben des erfassten Anomaliedetektionssignals in den Gate-Treiber (110), der mit dem anderen Zweig (100) verbunden ist, um den Gate-Treiber (110), in den das erfasste Anomaliedetektionssignal eingegeben ist, anzuhalten.

6. Fehlerdetektionsverfahren nach Anspruch 4, das ferner Folgendes umfasst:
Senden des Anomaliedetektionssignals an eine Host-Steuerung, die einen Befehl an den Gate-Treiber (110) ausgibt, um die Leistungswandlervorrichtung anzuhalten.

## Revendications

1. Dispositif de détection de défaut (1, 2, 3, 4) configuré pour détecter si un état de connexion est normal ou anormal pour une ligne de commande (119), qui effectue une connexion électrique entre une borne auxiliaire (105, 106) pour commander un trajet pour une borne principale (103, 104) d'un élément de commutation à semi-conducteur (101) et une unité de commande (110) qui commande l'entraînement de l'élément de commutation à semi-conducteur (101),
dans lequel, le dispositif de détection de défaut (1, 2, 3, 4) est configuré de telle sorte que lorsqu'un taux de changement d'une tension de sortie délivrée en sortie depuis l'unité de commande (110) vers la ligne de commande (119) est supérieur à une valeur prescrite, il est déterminé qu'une anomalie de connexion est survenue dans la ligne de commande (119), et un signal de détection d'anomalie est délivré en sortie,
un bras (100) est formé pour l'élément de commutation à semi-conducteur (101),
le bras (100) inclut
l'élément de commutation à semi-conducteur (101),
une paire de paires de bornes principales (103, 104) configurées par les bornes principales de l'élément de commutation à semi-conducteur, et
une paire de paires de bornes auxiliaires (105, 106) qui commandent un courant circulant dans la paire de bornes principale,
un circuit de conversion de puissance est configuré en connectant des bornes principales (103, 104) d'une pluralité de bras en série entre une paire de lignes d'alimentation électrique, les bornes principales (103, 104) étant respectivement ouvertes et fermées par une pluralité des bras (100),
l'unité de commande (110) est un dispositif d'entraînement de grille qui est configuré pour appliquer un signal de commande à la borne auxiliaire,
la ligne de commande est un câblage de grille qui connecte la borne auxiliaire (105) et une borne de sortie du dispositif d'entraînement de grille (110),
le dispositif d'entraînement de grille (110) inclut
un circuit entraînement (112) qui est configuré pour recevoir une instruction depuis un dispositif de commande hôte qui donne une instruction au dispositif d'entraînement de grille (110) et pour générer le signal de commande,
un circuit de détermination de tension de grille (114, 401, 402) qui est configuré pour délivrer en sortie un signal de détermination de comparaison lorsqu'une tension de sortie du circuit de commande (112) dépasse une tension prédéterminée,
**caractérisé en ce que**
le dispositif d'entraînement de grille (110) inclut un circuit de retard (113) qui est configuré pour recevoir une instruction depuis le dispositif de commande et générer une sortie après un retard d'un temps prédéterminé, et
le circuit entraînement de grille (110) inclut un circuit OU exclusif(116) qui est configuré pour délivrer en sortie un OU exclusif par rapport à des sorties du circuit de retard (113) et du circuit de détermination de tension de grille (114, 401, 402), et
le dispositif d'entraînement de grille (110) est configuré pour générer un signal de détection d'anomalie sur la base d'un signal de sortie du circuit OU exclusif (116) lorsque le signal de détermination de comparaison délivré en sortie par le circuit de détermination de tension de grille (114, 401, 402) est entré avant un signal de retard délivré en sortie par le circuit de retard (113).

2. Dispositif de détection de défaut (1, 2, 3, 4) selon la revendication 1, dans lequel
lorsque le signal de détection d'anomalie est acquis en raison d'une occurrence de l'anomalie de connexion sur un côté de bras de la paire des bras (100), le signal de détection d'anomalie acquis est entré dans le dispositif d'entraînement de grille (110) connecté à l'autre bras (100) pour arrêter le dispositif d'entraînement de grille (110) vers lequel le signal de détection d'anomalie acquis est entré.

3. Dispositif de détection de défaut (1, 2, 3, 4) selon la revendication 1, dans lequel
le signal de détection d'anomalie est transmis à un dispositif de commande hôte qui donne une instruction au dispositif d'entraînement de grille (110) pour arrêter le circuit de conversion de puissance.

4. Procédé de détection de défaut pour détecter si un état de connexion est normal ou anormal pour une ligne de commande (119), qui effectue une connexion électrique entre une borne auxiliaire (105, 106) pour commander un trajet pour une borne principale (103, 104) d'un élément de commutation à semi-conducteur (101) et une unité de commande (110) qui commande l'entraînement de l'élément de commutation à semi-conducteur (101), le procédé comprenant les étapes consistant à :
lorsqu'un taux de changement d'une tension de sortie délivrée en sortie depuis l'unité de commande (110) vers la ligne de commande (119) est supérieur à une valeur prescrite, déterminer qu'une anomalie de connexion est survenue dans la ligne de commande (119), et délivrer en sortie un signal de détection d'anomalie ;
former un circuit de conversion de puissance en connectant une pluralité de bras (100) comprenant les éléments de commutation à semi-conducteur (101) en série entre une paire de lignes d'alimentation électrique ;
générer un signal de commande par l'intermédiaire de l'unité de commande (110) en tant que dispositif d'entraînement de grille qui commande l'ouverture et la fermeture d'un trajet pour les bornes principales (103, 104) des éléments de commutation à semi-conducteur (101) ;
appliquer le signal de commande à la borne auxiliaire (105, 106) de l'élément de commutation à semi-conducteur (101) via un câblage de grille ;
lorsque la ligne de commande (119) est déterminée comme ayant l'anomalie de connexion pendant un fonctionnement du circuit de conversion de puissance, déterminer que le câblage de grille qui connecte une borne de sortie du dispositif d'entraînement de grille (110) et la borne auxiliaire (105, 106) est dans un état non conducteur ;
commander un courant circulant dans une paire de paires de bornes principales (103, 104) configurées par les bornes principales des éléments de commutation à semi-conducteur (101) dans les bras respectifs (100), par une paire de paires de bornes auxiliaires (105, 106) ;
lorsqu'une instruction est reçue depuis un dispositif de commande hôte qui donne une instruction au dispositif d'entraînement de grille (110), générer le signal de commande par l'intermédiaire d'un circuit d'entraînement (112) ;
lorsqu'une tension de sortie du circuit d'entraînement (112) dépasse une tension prédéterminée, générer un signal de détermination de comparaison par l'intermédiaire d'un circuit de détermination de tension de grille (114, 401, 402) ;
**caractérisé par** le procédé comprenant en outre les étapes consistant à
générer un signal de retard par l'intermédiaire d'un circuit de retard (113) après qu'un temps prédéterminé soit retardé à partir de la réception de l'instruction en provenance du dispositif de commande ;
délivrer en sortie un OU exclusif par rapport aux signaux de sortie du circuit de retard (113) et du circuit de détermination de tension de grille (114, 401, 402), par l'intermédiaire d'un circuit OU exclusif (116) ; et
lorsque le signal de détermination de comparaison depuis le circuit de détermination de tension de grille (114, 401, 402) est entré avant le signal de retard du circuit de retard (113), générer un signal de détection d'anomalie par l'intermédiaire d'un signal de sortie du circuit OU exclusif (116).

5. Procédé de détection de défaut selon la revendication 4, comprenant en outre :
lorsque le signal de détection d'anomalie est acquis en raison d'une occurrence de l'anomalie de connexion dans un bras (100) de la paire de bras, entrer le signal de détection d'anomalie acquis dans le dispositif d'entraînement de grille (110) connecté à l'autre bras (100) pour arrêter le dispositif d'entraînement de grille (110) vers lequel le signal de détection d'anomalie acquis est entré.

6. Procédé de détection de défaut selon la revendication 4, comprenant en outre l'étape consistant à :
transmettre le signal de détection d'anomalie à un dispositif de commande hôte qui donne une instruction au dispositif d'entraînement de porte (110) pour arrêter le circuit de conversion de puissance.
